# EUROPÄISCHE PATENTSCHRIFT

(11) **EP 1 564 251 B1**
(45) Veröffentlichungstag und Bekanntmachung des Hinweises auf die Patenterteilung: **11.06.2008**
(21) Anmeldenummer: 05002012.2
(22) Anmeldetag: 01.02.2005
(51) Int. Cl.: C08L 65/00, H01L 51/30

(54) **Polythiophenformulierungen zur Verbesserung von organischen Leuchtdioden**
Polythiophene compositions for improving organic light-emitting diodes
Compositions de polythiophène pour améliorer les diodes organiques electroluminenscentes

(30) Priorität: 10.02.2004 DE 102004006583; 05.03.2004 DE 102004010811
(43) Veröffentlichungstag der Anmeldung: 17.08.2005
(73) Patentinhaber: H.C. Starck GmbH, 38642 Goslar (DE)
(72) Erfinder: Elschner, Andreas, Dr., 45479 Mülheim (DE); Jonas, Friedrich, Dr., 52066 Aachen (DE); Reuter, Knud, Dr., 47800 Krefeld (DE); Lövenich, Peter Wilfried, Dr., 51061 Köln (DE)
(74) Vertreter: Clauswitz, Kai-Uwe Wolfram

(56) Entgegenhaltungen:
- WO-A-20/04094501
- US-A1- 2004 010 115

## Beschreibung

Die Erfindung betrifft Formulierungen enthaltend Polythiophene und weitere Polymere, deren Verwendung und elektrolumineszierende Anordnungen enthaltend lochinjizierende Schichten enthaltend diese Formulierungen.

Eine elektrolumineszierende Anordnung (EL-Anordnung) ist dadurch charakterisiert, dass sie bei Anlegung einer elektrischen Spannung unter Stromfluss Licht aussendet. Derartige Anordnungen sind unter der Bezeichnung "Leuchtdioden" (LEDs = "light emitting diodes") seit langem bekannt. Die Emission von Licht kommt dadurch zustande, dass positive Ladungen (Löcher, "holes") und negative Ladungen (Elektronen, "electrons") unter Aussendung von Licht rekombinieren.

Die in der Technik gebräuchlichen LEDs bestehen alle zum überwiegenden Teil aus anorganischen Halbleitermaterialien. Seit einigen Jahren sind jedoch EL-Anordnungen bekannt, deren wesentliche Bestandteile organische Materialien sind.

Diese organischen EL-Anordnungen enthalten in der Regel eine oder mehrere Schichten aus organischen Ladungstransportverbindungen.

Der prinzipielle Schichtaufbau einer EL-Anordnung ist z.B. wie folgt:
- 1: Träger, Substrat
- 2: Basiselektrode
- 3: Löcher-injizierende Schicht
- 4: Löcher-transportierende Schicht
- 5: Emitter-Schicht
- 6: Elektronen-transportierende Schicht
- 7: Elektronen-injizierende Schicht
- 8: Topelektrode
- 9: Kontakte
- 10: Umhüllung, Verkapselung

Dieser Aufbau stellt den detailliertesten Fall dar und kann vereinfacht werden, indem einzelne Schichten weggelassen werden, so dass eine Schicht mehrere Aufgaben übernimmt. Im einfachsten Fall besteht eine EL-Anordnung aus zwei Elektroden, zwischen denen sich eine organische Schicht befindet, die alle Funktionen - inklusive der Emission von Licht - erfüllt.

Es hat sich aber in der Praxis gezeigt, dass zur Erhöhung der Leuchtdichte elektronen- und/oder lochinjizierende Schichten in den elektrolumineszierenden Aufbauten besonders vorteilhaft sind.

Aus der EP-A-686 662 ist bekannt, spezielle Mischungen aus leitfähigen organischen polymeren Leitern wie Poly(3,4-ethylendioxythiophen) und beispielsweise Polyhydroxyverbindungen oder Lactamen als Elektrode in Elektrolumineszenzanzeigen einzusetzen. Es hat sich aber in der Praxis gezeigt, dass diese Elektroden besonders für großflächige Anzeigen eine nicht ausreichende Leitfähigkeit aufweisen. Für kleine Anzeigen (Leuchtfläche < 1cm²) reicht die Leitfähigkeit dagegen aus.

Aus der DE-A-196 27 071 ist bekannt, polymere organische Leiter, z.B. Poly(3,4-ethylendioxythiophen), als lochinjizierende Schichten einzusetzen. Hierdurch kann die Leuchtstärke der elektrolumineszierenden Anzeigen gegenüber Aufbauten ohne den Einsatz polymerer organischer Zwischenschichten deutlich gesteigert werden. Durch Reduzierung der Teilchengröße der Poly(3,4-alkylendioxythiophen)-Dispersionen lässt sich die Leitfähigkeit gezielt einstellen. Damit gelingt es, ein elektrisches Übersprechen benachbarter Adresslinien (crosstalk) insbesondere in Passiv-Matrix-Anzeigen zu verhindern (EP-A-1 227 529).

Die Lebensdauer dieser Anzeigen ist aber für viele praktische Anwendungen immer noch nicht ausreichend.

Es bestand daher weiterhin Bedarf, EL-Anordnungen herzustellen, die neben einer hohen Leuchtstärke (Leuchtintensität) eine höhere Lebensdauer aufweisen als bekannte EL-Anordnungen.

Die Aufgabe der vorliegenden Erfindung bestand daher darin, geeignete Formulierungen zur Herstellung solcher EL-Anordnungen aufzufinden und bereitzustellen. Eine weitere Aufgabe bestand darin, aus diesen Materialien verbesserte EL-Anordnungen herzustellen.

Überraschend wurde gefunden, dass sich bisher unbekannte Formulierungen enthaltend gegebenenfalls substituierte Polythiophene oder gegebenenfalls substituierte Polyaniline oder Polypyrrole und weitere Polymere hervorragend zur Herstellung lochinjizierender Schichten für EL-Anordnungen eignen und die erhaltenen EL-Anordnungen eine deutlich höhere Lebensdauer aufweisen als bekannte EL-Anordnungen.

Gegenstand der vorliegenden Erfindung sind daher Formulierungen enthaltend
A) wenigstens ein Polythiophen enthaltend wiederkehrende Einheiten der allgemeinen Formel (I), 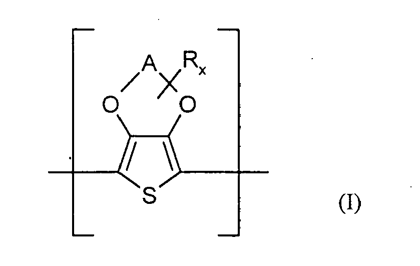 worin
   - A: für einen gegebenenfalls substituierten C₁-C₅-Alkylenrest, bevorzugt für einen gegebenenfalls substituierten Ethylen- oder Propylenrest, besonders bevorzugt für einen 1,2-Ethandiyl-Rest steht,
   - R: für einen linearen oder verzweigten C₁-C₁₈-Alkylrest, bevorzugt für einen linearen oder verzweigten C₁-C₁₄-Alkylrest, besonders bevorzugt für einen Methyl- oder Ethylrest, einen C₅-C₁₂-Cycloalkylrest, einen C₆-C₁₄-Arylrest, einen C₇-C₁₈-Aralkylrest, einen C₁-C₄-Hydroxyalkylrest oder einen Hydroxylrest steht,
   - x: für eine ganze Zahl von 0 bis 8, bevorzugt für 0, 1 oder 2, besonders bevorzugt für 0 oder 1 steht und
   für den Fall, dass mehrere Reste R an A gebunden sind, diese gleich oder unterschiedlich sein können,
B) wenigstens ein SO₃⁻M⁺- oder COO⁻M⁺-Gruppen enthaltendes Polymer, wobei M⁺ für H⁺, Li⁺, Na⁺, K⁺, Rb⁺, Cs⁺ oder NH₄⁺, bevorzugt für H⁺, Na⁺ oder K⁺ steht, und
C) wenigstens ein SO₃⁻M⁺- oder COO⁻M⁺-Gruppen enthaltendes, teilfluoriertes oder perfluoriertes Polymer, wobei M⁺ für H⁺, Li⁺, Na⁺, K⁺, Rb⁺, Cs⁺ oder NH₄⁺, bevorzugt für H⁺, Na⁺ oder K⁺ steht.

Die allgemeine Formel (I) ist so zu verstehen, dass der Substituent R x-mal an den Alkylenrest A gebunden sein kann.

Formulierung (Zusammensetzung) im Sinne der Erfindung ist jede Mischung der Komponenten A), B) und C) als Feststoff, Lösung oder Dispersion. Anstelle des Polythiophens A) können auch andere bekannte leitfähige Polymere A) eingesetzt werden, insbesondere gegebenenfalls substituierte Polyaniline oder Polypyrrole. Diese verschiedenen leitfähigen Polymere können allein oder in beliebiger Mischung eingesetzt werden.

Unter substituiert ist hier und im folgenden, wenn nicht ausdrücklich anders erwähnt, eine Substitution mit einer Gruppe ausgewählt aus der Reihe:

Alkyl, bevorzugt C₁-C₂₀-Alkyl-, Cycloalkyl-, bevorzugt C₃-C₂₀-Cycloalkyl-, Aryl-, bevorzugt C₅-C₁₄-Aryl-, Halogen-, bevorzugt Cl, Br, J, Ether-, Thioether-, Disulfid-, Sulfoxid-, Sulfon-, Amino-, Aldehyd-, Keto-, Carbonsäureester-, Cyano-, Alkylsilan- und Alkoxysilangruppen sowie Carboxylamidgruppen zu verstehen.

In bevorzugten Ausführungsformen der erfindungsgemäßen Formulierung ist wenigstens ein Polythiophen enthaltend wiederkehrende Einheiten der allgemeinen Formel (I) ein solches enthaltend wiederkehrende Einheiten der allgemeinen Formel (Ia), 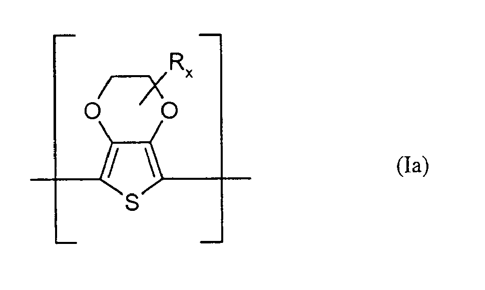 worin
R und x die oben genannte Bedeutung haben.

In ganz besonders bevorzugten Formulierungen gemäß obiger Beschreibung steht x für 0 oder 1. Für den Fall, dass x gleich 1 ist, steht R besonders bevorzugt für Methyl oder Hydroxymethyl.

In weiteren bevorzugten Ausführungsformen der erfindungsgemäßen Formulierung ist wenigstens ein Polythiophen A) enthaltend wiederkehrende Einheiten der allgemeinen Formel (I) ein solches enthaltend wiederkehrende Einheiten der allgemeinen Formel (Iaa)

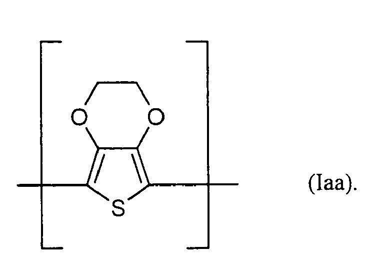

Unter dem Präfix Poly- ist im Rahmen der Erfindung zu verstehen, dass mehr als eine gleiche oder verschiedene wiederkehrende Einheit im Polymeren bzw. Polythiophen enthalten ist. Die Polythiophene enthalten insgesamt n wiederkehrende Einheiten der allgemeinen Formel (I), wobei n eine ganze Zahl von 2 bis 2000, bevorzugt 2 bis 100, sein kann. Die wiederkehrenden Einheiten der allgemeinen Formel (I) können innerhalb eines Polythiophens jeweils gleich oder verschieden sein. Bevorzugt sind Polythiophene enthaltend jeweils gleiche wiederkehrende Einheiten der allgemeinen Formel (I).

Unter wiederkehrenden Einheiten sind im Rahmen der Erfindung Einheiten der allgemeinen Formeln (I), (Ia) oder (Iaa), im Folgenden als wiederkehrende Einheiten der allgemeinen Formel (I) zusammengefasst, zu verstehen, unabhängig davon, ob sie einmal oder mehrmals im Polythiophen enthalten sind. D.h. Einheiten der allgemeinen Formel (I) sind auch dann als wiederkehrende Einheiten zu verstehen, wenn sie nur einmal im Polythiophen enthalten sind.

Erfindungsgemäße Formulierungen können auch solche sein, die neben wenigstens einem der vorangehend beschriebenen Polythiophene A) enthaltend wiederkehrende Einheiten der allgemeinen Formel (I) in der Mischung weitere leitfähige Polymere, wie Polyaniline oder Polypyrrole enthalten.

An den Endgruppen tragen die Polythiophene bevorzugt jeweils H.

Die Polythiophene A) enthalten insgesamt n wiederkehrende Einheiten der allgemeinen Formel (I), wobei n bevorzugt eine ganze Zahl von 2 bis 1000, bevorzugt 3 bis 100, besonders bevorzugt 4 bis 15 ist.

C₁-C₅-Alkylenreste A sind insbesondere Methylen, Ethylen, n-Propylen, n-Butylen oder n-Pentylen. C₁-C₁₈-Alkyl steht insbesondere für lineare oder verzweigte C₁-C₁₈-Alkylreste, beispielsweise Methyl, Ethyl, n- oder iso-Propyl, n-, iso-, sec- oder tert-Butyl, n-Pentyl, 1-Methylbutyl, 2-Methylbutyl, 3-Methylbutyl, 1-Ethylpropyl, 1,1-Dimethylpropyl, 1,2-Dimethylpropyl, 2,2-Dimethylpropyl, n-Hexyl, n-Heptyl, n-Octyl, 2-Ethylhexyl, n-Nonyl, n-Decyl, n-Undecyl, n-Dodecyl, n-Tridecyl, n-Tetradecyl, n-Hexadecyl oder n-Octadecyl, C₅-C₁₂-Cycloalkyl für C₅-C₁₂-Cycloalkylreste wie beispielsweise Cyclopentyl, Cyclohexyl, Cycloheptyl, Cyclooctyl, Cyclononyl oder Cyclodecyl, C₅-C₁₄-Aryl für C₅-C₁₄-Arylreste, beispielsweise Phenyl oder Naphthyl, und C₇-C₁₈-Aralkyl für C₇-C₁₈-Aralkylreste, beispielsweise Benzyl, o-, m-, p-Tolyl, 2,3-, 2,4-, 2,5-, 2,6-, 3,4-, 3,5-Xylyl oder Mesityl. Die vorangehende Aufzählung dient der beispielhaften Erläuterung der Erfindung und ist nicht als abschließend zu betrachten.

Die Herstellung der vorangehend beschriebenen Polythiophene A) enthaltend wiederkehrende Einheiten der allgemeinen Formel (I) ist prinzipiell in EP-A 440 957 beschrieben.

Die Polymerisation der entsprechenden monomeren Ausgangsverbindungen wird mit geeigneten Oxidationsmitteln in geeigneten Lösungsmitteln durchgeführt. Beispiele für geeignete Oxidationsmittel sind Eisen(III)-salze, insbesondere FeCl₃ und Eisen(III)-salze aromatischer und aliphatischer Sulfonsäuren, H₂O₂, K₂Cr₂O₇, K₂S₂O₈, Na₂S₂O₈, KMnO₄, Alkaliperborate und Alkali- oder Ammoniumpersulfate oder Mischungen dieser Oxidationsmittel. Weitere geeignete Oxidationsmittel sind beispielsweise in Handbook of Conducting Polymers (Ed. Skotheim, T.A.), Marcel Dekker: New York, 1986, Vol. 1, 46-57 beschrieben. Besonders bevorzugte Oxidationsmittel sind FeCl₃, Na₂S₂O₈ und K₂S₂O₈ oder Mischungen hiervon. Die Polymerisation wird bevorzugt bei einer Reaktionstemperatur von -20 bis 100°C durchgeführt. Besonders bevorzugt sind Reaktionstemperaturen von 20 bis 100°C. Gegebenenfalls wird die Reaktionslösung anschließend mit wenigstens einem Ionenaustauscher behandelt.

Geeignete Lösungsmittel für die vorgenannte Reaktion sind z.B. polare Lösungsmittel, beispielsweise Wasser, Alkohole wie Methanol, Ethanol, 2-Propanol, n-Propanol, n-Butanol, Diacetonalkohol, Ethylenglykol, Glycerin oder Mischungen aus diesen. Ebenfalls geeignet sind aliphatische Ketone wie Aceton und Methylethylketon, aliphatische Nitrile wie Acetonitril, aliphatische und cyclische Amide wie N,N-Dimethylacetamid, N,N-Dimethylformamid (DMF) und 1-Methyl-2-pyrrolidon (NMP), Ether wie Tetrahydrofuran (THF) sowie Sulfoxide wie Dimethylsulfoxid (DMSO) oder Mischungen aus diesen untereinander oder mit den vorangehend aufgeführten Lösungsmitteln.

Die entsprechenden monomeren Verbindungen zur Herstellung von Polythiophenen A) enthaltend wiederkehrende Einheiten der allgemeinen Formel (I) sind bekannt. Ihre Herstellung ist beispielsweise durch Umsetzung der Alkalisalze der 3,4-Dihydroxythiophen-2,5-dicarbonsäureester mit den entsprechenden Alkylen-dihalogeniden und nachfolgende Decarboxylierung der freien 3,4-(Alkylendioxy)thiophen-2,5-dicarbonsäuren möglich (siehe z. B. Tetrahedron 1967, 23, 2437 - 2441 und J. Am. Chem. Soc. 1945, 67, 2217 - 2218).

Die resultierenden Polythiophene sind sehr gut in den polaren Lösungsmitteln oder Lösungsmittelgemischen löslich oder dispergierbar.

Die erfindungsgemäßen Formulierungen enthalten neben wenigstens einem teilfluorierten bzw. perfluorierten Polymer C) wenigstens ein weiteres SO₃⁻M⁺- oder COO⁻M⁺-Gruppen enthaltendes Polymer B). Geeignete SO₃⁻M⁺- oder COO⁻M⁺-Gruppen enthaltende Polymere B) sind bevorzugt solche, die keine vollständig konjugierte Hauptkette enthalten, im Folgenden auch kurz als nicht konjugiert bezeichnet. Beispielhaft für geeignete SO₃⁻M⁺- oder COO⁻M⁺-Gruppen enthaltende Polymere B) seien polymere Carbonsäuren, wie Polyacrylsäuren, Polymethacrylsäure oder Polymaleinsäuren, oder polymere Sulfonsäuren, wie Polystyrolsulfonsäuren und Polyvinylsulfonsäuren genannt. Weiterhin kommen auch Copolymere von Vinylcarbon- und Vinylsulfonsäuren mit anderen polymerisierbaren Monomeren, wie Acrylsäureestern und Styrol, in Frage. Besonders geeignet sind Polystyrolsulfonsäure, Poly-(styrolsulfonsäure-co-maleinsäure) oder Poly-(vinylsulfonsäure). Ganz besonders geeignete Formulierungen sind dadurch gekennzeichnet, dass sie als wenigstens ein SO₃⁻M⁺- oder COO⁻M⁺-Gruppen enthaltendes Polymer B) Polystyrolsulfonsäure (PSS) enthalten.

Bevorzugt sind diese Polymere B) in polaren Lösungsmitteln wie Wasser, Alkoholen wie Methanol, Ethanol, 2-Propanol, n-Propanol, n-Butanol, Diacetonalkohol, Ethylenglykol, Glycerin, aliphatischen Ketonen wie Aceton und Methylethylketon, aliphatischen Nitrilen wie Acetonitril, aliphatischen und cyclischen Amiden wie N,N-Dimethylacetamid, N,N-Dimethylformamid (DMF) und 1-Methyl-2-pyrrolidon (NMP), Ethern wie Tetrahydrofuran (THF) sowie Sulfoxiden wie Dimethylsulfoxid (DMSO) oder Mischungen enthaltend diese, bevorzugt in Wasser, Alkoholen wie Methanol, Ethanol, 2-Propanol, n-Propanol und n-Butanol oder Mischungen aus diesen löslich oder dispergierbar.

Besonders geeignete Formulierungen gemäß obiger Beschreibung sind dadurch gekennzeichnet, dass sie als wenigstens ein SO₃⁻M⁺- oder COO⁻M⁺-Gruppen enthaltendes teilfluoriertes oder perfluoriertes Polymer C) beispielsweise solche enthaltend wiederkehrende Einheiten der Formeln (II-a) und (II-b), 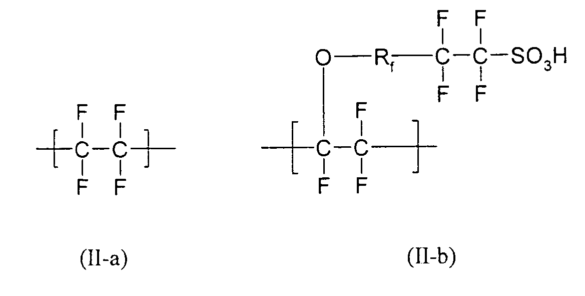 worin R_{f} für einen Rest mit wenigstens einer, bevorzugt 1 bis 30 wiederkehrenden Einheit(en) der Formel (II-c) 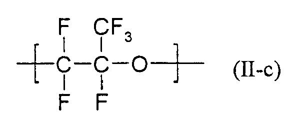 steht, enthalten. Solche perfluorierten Polymere sind beispielsweise die kommerziell unter dem Handelsnamen Nafion® oder in gelöster Form unter dem Handelsnamen Liquion® erhältlichen Polymere.

In besonders bevorzugten Ausführungsformen enthält die neue Formulierung als wenigstens ein SO₃⁻M⁺- oder COO⁻M⁺-Gruppen enthaltendes Polymer C) Nafion® (Copolymer aus Tetrafluorethylen und dem Trifluorvinylether des Poly(hexafluorpropylenoxid)mono(tetrafluorvinylsulfonsäure)-ethers).

Besonders bevorzugt werden Formulierungen, die als SO₃⁻M⁺- oder COO⁻M⁺-Gruppen enthaltendes Polymer B) Polystyrolsulfonsäure (PSS) und als SO₃⁻M⁺- oder COO⁻M⁺-Gruppen enthaltendes teilfluoriertes oder perfluoriertes Polymer C) Nafion® (Copolymer aus Tetrafluorethylen und dem Trifluorvinylether des Poly(hexafluorpropylenoxid)mono(tetrafluorvinylsulfonsäure)-ethers) enthalten.

Das Molekulargewicht der Polysäuren beträgt vorzugsweise 1 000 bis 2 000 000, besonders bevorzugt 2 000 bis 500 000. Die Polysäuren oder ihre Alkalisalze sind im Handel erhältlich, z.B. Polystyrolsulfonsäuren und Polyacrylsäuren, oder aber nach bekannten Verfahren herstellbar (siehe z.B. Houben Weyl, Methoden der organischen Chemie, Bd. E 20 Makromolekulare Stoffe, Teil 2, (1987), S. 1141 u.f).

Ganz besonders bevorzugt sind Formulierungen bei denen das Gewichtsverhältnis von Polythiophen(en) A) zu SO₃⁻M⁺- oder COO⁻M⁺-Gruppen enthaltendem(n) Polymer(en) B) von 1 zu 2 (1:2) bis 1 zu 25 (1:25), bevorzugt von 1 zu 2 (1:2) bis 1 zu 20 (1:20) beträgt.

Weiterhin ganz besonders bevorzugt sind Formulierungen bei denen das Gewichtsverhältnis von Polythiophen(en) A) zu SO₃⁻M⁺- oder COO⁻M⁺-Gruppen enthaltendem(n), teilfluoriertem(n) oder perfluoriertem(n) Polymer(en) C) von 1 zu 1 (1:1) bis 1 zu 50 (1:50), bevorzugt von 1 zu 2 (1:2) bis 1 zu 30 (1:30) beträgt.

Alle beliebigen Kombinationen der beiden vorangehend beschriebenen Gewichtsverhältnisse von Polythiophen(en) A) zu SO₃⁻M⁺- oder COO⁻M⁺-Gruppen enthaltendem(n) Polymer(en) B) und Polythiophen(en) A) zu SO₃⁻M⁺- oder COO⁻M⁺-Gruppen enthaltendem(n), teilfluoriertem(n) oder perfluoriertem(n) Polymer(en) C) können in den bevorzugten Formulierungen realisiert sein und gelten hiermit als offenbart.

Weiterhin können die neuen Formulierungen zusätzlich wenigstens ein polares Verdünnungsmittel D) (polares Lösungsmittel) enthalten. Unter polaren Verdünnungsmitteln D) (polaren Lösungsmitteln) sind im Rahmen der Erfindung Verdünnungsmittel mit einem Löslichkeitsparameter δ von 16 MPa^{1/2} und größer, bevorzugt 19 MPa^{1/2} und größer zu verstehen. Die Messung von Löslichkeitsparametern findet in der Regel bei Standardtemperatur (20°C) statt. Zur Messung und Berechnung von Löslichkeitsparametern siehe J. Brandrup et al., Polymer Handbook, 4^{th} Ed., 1999, VII/675 - VII/688. Löslichkeitsparameter sind tabelliert, z.B. in J. Brandrup et al., Polymer Handbook, 4^{th} Ed., 1999, VII/688 - VII/697. Bevorzugte polare Verdünnungsmittel D) sind Wasser, Alkohole wie Methanol, Ethanol, 2-Propanol, n-Propanol, n-Butanol, Diacetonalkohol, Ethylenglykol, Glycerin, aliphatische Ketone wie Aceton und Methylethylketon, aliphatische Nitrile wie Acetonitril, aliphatische und cyclische Amide wie N,N-Dimethylacetamid, N,N-Dimethylformamid (DMF) und 1-Methyl-2-pyrrolidon (NMP), Ether wie Tetrahydrofuran (THF) sowie Sulfoxide wie Dimethylsulfoxid (DMSO) oder Mischungen enthaltend diese. Besonders bevorzugte polare Verdünnungsmittel D) sind Wasser, Alkohole oder Mischungen enthaltend diese, ganz besonders bevorzugt sind Wasser, Methanol, Ethanol, n-Propanol, 2-Propanol oder n-Butanol oder Mischungen enthaltend diese. In bevorzugten Ausführungsformen enthalten die neuen Formulierungen als polares Verdünnungsmittel D) Mischungen aus Wasser und wenigstens einem Alkohol.

Solche neuen bevorzugten Formulierungen enthaltend wenigstens ein polares Verdünnungsmittel D) enthalten bevorzugt 99.99 bis 80 Gew.-%, besonders bevorzugt 99,8 bis 95 Gew.-% polare(s) Verdünnungsmittel und weisen einen Feststoffgehalt von 0,01 bis 20 Gew.-%, besonders bevorzugt 0,2 bis 5 Gew.-% auf, d.h. enthalten insgesamt 0,01 bis 20 Gew.-%, besonders bevorzugt 0,2 bis 5 Gew.-% Polythiophen(e) A), SO₃⁻M⁺- oder COO⁻M⁺-Gruppen enthaltende(s) Polymer(e) B) und C) und gegebenenfalls weitere enthaltene Komponenten, wie z.B. Bindemittel, Vernetzungsmittel und/oder Tenside, in gelöster und/oder dispergierter Form.

Die Viskosität bei 20°C von neuen bevorzugten Formulierungen enthaltend wenigstens ein polares Verdünnungsmittel liegt zwischen der Viskosität des Verdünnungsmittels und 200 mPas, bevorzugt < 100 mPas.

Zur Einstellung des gewünschten Feststoffgehaltes und der erforderlichen Viskosität kann aus den Formulierungen die gewünschte Menge Verdünnungsmittel durch Destillation, bevorzugt im Vakuum, oder durch andere Verfahren, z.B. Ultrafiltration, entfernt werden.

Den erfindungsgemäßen Formulierungen können außerdem organische, polymere Bindemittel und/oder organische, niedermolekulare Vernetzungsmittel oder Tenside zugesetzt werden. Entsprechende Bindemittel sind z.B. in EP-A-564 911 beschrieben. Beispielhaft seien hier Polyvinylcarbazol als Bindemittel, Silane, wie Silquest® A187 (Fa. OSi specialities) oder Tenside als Vernetzungsmittel, wie das Fluortensid FT 248 (Bayer AG) aufgeführt.

Die Formulierungen können bevorzugt geringe Mengen ionischer Verunreinigungen in den Grenzen wie sie in EP-A-991 303 beschrieben sind, enthalten. Bevorzugt enthalten die Formulierungen weniger als 1000 ppm ionischer Verunreinigungen.

Die erfindungsgemäßen Formulierungen können auf einfache Weise hergestellt werden. Beispielsweise ist es möglich, eine bereits fertige Mischung enthaltend wenigstens ein SO₃⁻M⁺- oder COO⁻M⁺-Gruppen enthaltendes Polymer B) und wenigstens ein Polythiophen A) mit wenigstens einem teilfluorierten oder perfluorierten, SO₃⁻M⁺- oder COO⁻M⁺-Gruppen enthaltenden Polymer C) zu mischen und dieses Gemisch gegebenenfalls mit wenigstens einem Verdünnungsmittel zu versetzen, bevorzugt in wenigstens einem Verdünnungsmittel ganz oder teilweise zu lösen oder zu dispergieren. Es ist auch möglich, wenigstens eine bereits fertige Mischung enthaltend ein SO₃⁻M⁺- oder COO⁻M⁺-Gruppen enthaltendes Polymer B) und wenigstens ein Polythiophen A) vorab mit wenigstens einem Verdünnungsmittel D) zu versetzen, bevorzugt in wenigstens einem Verdünnungsmittel D) ganz oder teilweise zu lösen oder zu dispergieren, wenigstens ein SO₃⁻M⁺- oder COO⁻M⁺-Gruppen enthaltendes teilfluoriertes oder perfluoriertes Polymer C) in einem Verdünnungsmittel zu lösen oder zu dispergieren und die Lösung(en) und/oder Dispersion(en) anschließend zu mischen. Gegebenenfalls kann aus dieser Mischung anschließend das Verdünnungsmittel D) oder Verdünnungsmittelgemisch ganz oder teilweise wieder entfernt werden, z.B. durch Destillation oder andere Verfahren.

Überraschend eignen sich die erfindungsgemäßen Formulierungen hervorragend für die Herstellung lochinjizierender oder lochtransportierender Schichten in EL-Anordnungen, organischen Solarzellen, organischen Laserdioden, organischen Dünnfilmtransistoren oder organischen Feldeffekttransistoren, zur Herstellung von Elektroden oder elektrisch leitfähiger Beschichtungen.

Daher ist ebenfalls Gegenstand der vorliegenden Erfindung die Verwendung der erfindungsgemäßen Formulierungen zur Herstellung lochinjizierender Schichten in EL-Anordnungen, zur Herstellung von Elektroden oder elektrisch leitfähiger Beschichtungen.

Diese EL-Anordnungen findet Verwendung als Anzeigeelemente ("Displays"), z. B. in Flach-Bildschirmen wie Laptop, Pager, Mobiltelefon, Navigationsgeräte, Auto-Radios, Kfz-Instrumententafeln, oder als Flächenstrahler, z.B. Lampen, Leuchtflächen, Hintergrundbeleuchtung für LCD-Displays, Schilder.

Insbesondere EL-Anordnungen mit einer lochinjizierenden Schicht enthaltend eine erfindungsgemäße Formulierung zeichnen sich durch eine hohe Leuchtstärke (Leuchtintensität) und eine deutlich höhere Lebensdauer aus als bekannte EL-Anordnungen.

Ebenfalls Gegenstand der vorliegenden Erfindung sind daher EL-Anordnungen insbesondere Leuchtdioden enthaltend eine lochinjizierende Schicht enthaltend eine erfindungsgemäße Formulierung. Bevorzugt sind dies solche EL-Anordnungen enthaltend wenigstens zwei Elektroden, wovon gegebenenfalls wenigstens eine auf ein gegebenenfalls transparentes Substrat aufgebracht ist, wenigstens eine Emitter-Schicht zwischen den beiden Elektroden und wenigstens eine lochinjizierenden Schicht zwischen einer der beiden Elektroden und der Emitter-Schicht, dadurch gekennzeichnet, dass die lochinjizierende Schicht eine erfindungsgemäße Formulierung enthält.

Bei der Herstellung von vielen großflächigen EL-Anordnungen, z.B. großflächigen elektrolumineszierenden Anzeigeelementen, ist es vorteilhaft, wenn mindestens eine der stromzuführenden Elektroden aus einem transparenten und leitfähigem Material besteht. Als solche transparenten und leitfähigen Elektroden-Materialien sind beispielsweise
a) Metalloxide, z.B. Indium-Zinn-Oxid (ITO), Zinnoxid (NESA), dotiertes Zinnoxid, dotiertes Zinkoxid etc.,
b) semi-transparente Metallfilme, z.B. Au, Pt, Ag, Cu etc.,
c) semi-transparente, leitfähige Polymere, z.B. Polythiophene, Polyaniline, Polypyrrole etc.
geeignet.

Bei einer Elektrode, die nicht aus einem der vorangehend aufgeführten transparenten und leitfähigen Materialien besteht, handelt es sich vorzugsweise um eine Metallelektrode, insbesondere um eine Metallkathode.

Geeignete Materialien für Metallkathoden sind die für elektrooptische Aufbauten gängigen Materialien und dem Fachmann bekannt. Als Metallkathode kommen bevorzugt solche aus Metallen mit geringer Austrittsarbeit wie Mg, Ca, Ba oder Metallsalzen wie LiF in Betracht.

Als gegebenenfalls transparentes Substrat eignet sich beispielsweise Glas, Dünnstglas (flexibles Glas) oder Kunststoffe, bevorzugt Kunststofffolien.

Besonders geeignete Kunststoffe für das Substrat sind: Polycarbonate, Polyester wie z.B. PET und PEN (Polyethylenterephthalat bzw. Polyethylennaphthalindicarboxylat), Copolycarbonate, Polyacrylat, Polysulfon, Polyethersulfon (PES), Polyimid, Polyethylen, Polypropylen oder cyclische Polyolefine bzw. cyclische Olefincopolymere (COC), hydrierte Styrolpolymere oder hydrierte Styrolcopolymere.

Geeignete Polymerunterlagen können beispielsweise Folien wie Polyesterfolien, PES-Folien der Firma Sumitomo oder Polycarbonatfolien der Firma Bayer AG (Makrofol®) sein.

Zwischen dem Substrat und der Elektrode kann sich eine Haftvermittlerschicht befinden. Geeignete Haftvermittler sind beispielsweise Silane. Bevorzugt sind Epoxysilane, wie beispielsweise 3-Glycidoxypropyltrimethoxysilan (Silquest® A187, Fa. OSi specialities). Es können auch andere Haftvermittler mit hydrophilen Oberflächeneigenschaften verwendet werden. So wird z.B. eine dünne Schicht aus PEDT:PSS als geeigneter Haftvermittler für PEDT beschrieben (Hohnholz et al., Chem. Commun. 2001, 2444-2445).

In der Emitter-Schicht der erfindungsgemäßen EL-Anordnung ist wenigstens ein Emittermaterial enthalten. Geeignete Emittermaterialien sind die für elektrooptische Aufbauten gängigen und dem Fachmann bekannt. Als Emittermaterialien kommen bevorzugt konjugierte Polymere wie Polyphenylenvinylene und/oder Polyfluorene, wie die beispielsweise in WO-A 90/13148 beschriebenen Polyparaphenylenvinylenderivate und Polyfluorenderivate, oder Emitter aus der Klasse der niedermolekularen Emitter, in Fachkreisen auch als "small molecules" bezeichnet, wie Aluminiumkomplexe, z.B. Tris(8-hydroxychinolinato)aluminium (Alq₃), Fluoreszenzfarbstoffe, z.B. Chinacridone, oder phosphoreszierende Emitter, z.B. Ir(ppy)₃, in Betracht. Emittermaterialien sind z.B. in DE-A 196 27 071 beschrieben.

Zusätzlich zu den vorangehend aufgeführten Schichten können weitere funktionelle Schichten in einem solchen elektrolumineszierenden Schichtaufbau (EL-Anordnung) enthalten sein, wie z.B. weitere ladungsinjizierende, z.B. elektroneninjizierende, ladungstransportierende oder ladungsblockierende Zwischenschichten. Solche Schichtaufbauten sind dem Fachmann bekannt und beispielsweise in J.R. Sheats et al., Science 273, (1996), 884 beschrieben. Eine Schicht kann auch mehrere Aufgaben übernehmen. Beispielsweise können die vorangehend aufgeführten Emittermaterialien in Kombination mit einer lochtransportierenden Zwischenschicht zwischen lochinjizierender und Emitter-Schicht eingesetzt werden (vgl. z.B. US 4,539,507 und US 5,150,006).

Die prinzipielle Herstellung solcher EL-Anordnungen ist dem Fachmann bekannt. Sie können beispielsweise so hergestellt werden, dass eine Elektrode aus Lösung oder Dispersion oder durch Aufdampfen auf ein Substrat aufgebracht wird. Z.B. werden Metalloxid- oder semi-transparente Metallfilmelektroden bevorzugt durch Aufdampfen, semi-transparente, leitfähige Polymerelektroden hingegen bevorzugt aus Lösung oder Dispersion auf das Substrat aufgebracht. Gegebenenfalls kann vor Aufbringen des Elektrodenmaterials auf das Substrat ein Haftvermittler - durch Aufdampfen oder aus Lösung oder Dispersion - aufgebracht werden. Einige solcher mit Elektrodenmaterial beschichteten Substrate sind auch bereits kommerziell erhältlich (z.B. K-Glas, ITO beschichtete Glassubstrate). Auf die Elektrode kann anschließend die lochinjizierende Schicht aufgebracht werden, was bei den erfindungsgemäßen EL-Anordnungen mit lochinjizierender Schicht enthaltend eine erfindungsgemäße Formulierung vorteilhafterweise aus Lösung oder Dispersion erfolgt. Auf die lochinjizierende Schicht werden anschließend die weiteren Schichten in der einleitend aufgeführten Reihenfolge - unter Berücksichtigung, dass einzelne Schichten weggelassen werden können - je nach eingesetztem Material aus Lösung oder Dispersion oder durch Aufdampfen aufgebracht. Anschließend wird die Schichtanordnung kontaktiert und gekapselt.

Die Herstellung der lochinjizierenden Schicht enthaltend eine erfindungsgemäße Formulierung erfolgt nach bekannten Technologien. Dazu wird eine erfindungsgemäße Formulierung - gegebenenfalls in einem Lösungsmittel - auf einer Elektrode, bevorzugt der Basiselektrode, als Film aufgetragen. Als Lösungsmittel eignen sich die oben aufgeführten polaren Verdünnungsmittel, bevorzugt Wasser, Alkohole oder Mischungen aus diesen. Geeignete Alkohole sind z.B. Methanol, Ethanol, n-Propanol, 2-Propanol und n-Butanol.

Die Verwendung dieser Lösungsmittel hat den Vorteil, dass weitere Schichten aus organischen Lösungsmitteln, wie aromatischen oder aliphatischen Kohlenwasserstoffgemischen aufgebracht werden können, ohne dass die lochinjizierende Schicht angegriffen wird.

Die erfindungsgemäße Formulierung - gegebenenfalls in einem Lösungsmittel - kann beispielsweise durch Drucktechniken wie Spincoaten, Casting, Rakeln, Drucken, Vorhanggießen etc. auf der Elektrode gleichmäßig verteilt werden. Anschließend können die Schichten bei Raumtemperatur oder Temperaturen bis 300°C, bevorzugt 100 bis 200°C getrocknet werden.

Die erfindungsgemäße Formulierung - gegebenenfalls in einem Lösungsmittel - kann außerdem bevorzugt durch Techniken wie Ink-Jet strukturiert aufgebracht werden. Diese Technik ist dem Fachmann bekannt und unter Einsatz wasserlöslicher und dispergierter Polythiophene wie 3,4-Polyethylendioxythiophen:Polystyrolsulfonsäure (PEDT:PSS) z.B. in Science, Vol. 279, 1135, 1998 und DE-A 198 41 804 beschrieben.

Vorzugsweise werden die erfindungsgemäßen Formulierungen - gegebenenfalls in einem Lösungsmittel - vor der Applizierung durch ein Filter filtriert.

Besonders gut zum Reinigen filtrierbare Formulierungen werden beispielsweise erhalten, wenn in Lösungsmittel D) bezogen auf ein Gewichtsteil Polythiophen(e) enthaltend wiederkehrende Einheiten der allgemeinen Formel (I) bevorzugt 1 bis 30 Gewichtsteile, besonders bevorzugt 2 bis 25 Gewichtsteile des oder der SO₃⁻M⁺- oder COO⁻M⁺-Gruppen enthaltende(n) Polymer(e) B) verwendet werden.

Die Dicke der lochinjizierenden Schicht beträgt beispielsweise 3 bis 500 nm, bevorzugt 10 bis 200 nm.

Der Einfluss einer lochinjizierenden Schicht enthaltend eine erfindungsgemäße Formulierung auf die Eigenschaften der EL-Anordnung kann in einem speziellen Aufbau einer solchen erfindungsgemäßen EL-Anordnung getestet werden. Dazu wird die lochinjizierende Schicht auf nasschemisch gereinigtes ITO-Substrat mittels Spin-Coater aufgebracht. Anschließend wird die Schicht bei 100-200°C für 5 min getrocknet. Die Schichtdicke beträgt je nach Spingeschwindigkeit 20-300 nm. Als Emitter-Schicht wird eine 1 gew.-%ige Lösung eines polyfluorenbasierten Emittermaterials (Green 1300 LUMATION™ der Fa. Dow Chemical Company) in Xylol aufgeschleudert. Die Dicke der Emitterschicht beträgt typischerweise 60-120 nm. Als Kathode wird abschließend eine 5 nm dicke Ba-Schicht und darauf eine 200 nm dicke Ag-Schicht aufgedampft. Durch Kontaktierung der Indiumzinnoxid(ITO)-Anode und der Metall-Kathode werden mittels eines Kennlinienschreibers und einer kalibrierten Photodiode Strom-Spannungs-Leuchtdichte-Kennlinien aufgenommen und Lebensdauern gemessen. Dazu wird durch die Anordnung ein konstanter elektrischer Strom oder ein Wechselstrom geschickt, und die Spannung und die Leuchtdichte werden zeitabhängig verfolgt.

Die erfindungsgemäßen organischen Leuchtdioden zeichnen sich durch hohe Lebensdauer, hohe Leuchtstärke, niedrige Einsatzspannungen und ein hohes Gleichrichtungsverhältnis aus. Im Vergleich zu bekannten Leuchtdioden mit lochinjizierenden Schichten hergestellt aus einer Poly(3,4-ethylendioxythiophen):Polystyrolsulfonsäure(PEDT:PSS)-Dispersion (Baytron® P, H.C. Starck GmbH) wurde überraschend gefunden, dass die Lebensdauern erfindungsgemäßer organischer Leuchtdioden mit lochinjizierender Schicht enthaltend eine erfindungsgemäße Formulierung signifikant höher sind.

### Beispiele

### Beispiel 1

### Herstellung einer Formulierung aus Poly(3,4-ethylendioxythiophen)/Polystyrolsulfonsäure und einem perfluorierten Polymer.

40g einer 1,32 %igen Poly(3,4-ethylendioxythiophen)/Polystyrolsulfonsäure-Lösung (H.C. Starck GmbH, Baytron® P Versuchsprodukt, TP AI 4083, Gew.-Verhältnis PEDT/PSS 1:6) werden mit 9,96 g einer 5,30 Gew.-% Lösung aus Nafion® in einem Gemisch aus niederaliphatischen Alkoholen und Wasser (Nafion® perfluorinated ion-exchange resin, 5 wt % solution in lower aliphatic alcohols/H₂O, CAS-Nr. 66796-30-3, Aldrich-Best.-Nr. 27,470-4, nachgemessener Feststoffgehalt 5,30 Gew.-%) gemischt. Das Gewichts-Verhältnis von PEDT/PSS/Nafion® beträgt 1:6:7 .

### Beispiel 2

Die erfindungsgemäße Formulierung aus Beispiel 1 wird zum Aufbau einer organischen Leuchtdiode (OLED) genutzt. Bei der Herstellung der OLED wird folgendermaßen vorgegangen:

### 1. Vorbereitung des ITO-beschichteten Substrats

ITO-beschichtetes Glas (Merck Balzers AG, FL, Part. No. 253 674 XO) wird in 50 mm x 50 mmgroße Stücke (Substrate) geschnitten. Die ITO-Schicht wird mit üblicher Photoresisttechnik und anschließendem Abätzen in FeCl₃-Lösung strukturiert. Die isolierten ITO-Streifen haben eine Breite von 2,0 mm. Die Substrate werden anschließend in 3 %iger wässriger Mukasollösung im Ultraschallbad 15 min lang gereinigt. Danach werden die Substrate mit destilliertem Wasser gespült und in einer Zentrifuge trocken geschleudert. Dieser Spül- und Trockenvorgang wird 10 mal wiederholt. Unmittelbar vor der Beschichtung werden die ITO-beschichteten Seiten in einem UV/Ozon-Reaktor (PR-100, UVP Inc., Cambridge, GB) für 10 min gereinigt.

### 2. Aufbringen der lochinjizierenden Schicht

Etwa 10 ml der erfindungsgemäßen Formulierung aus Beispiel 1 werden filtriert (Millipore HV, 0,45 µm). Das gereinigte ITO-beschichtete Substrat wird auf eine Lackschleuder gelegt und die filtrierte Lösung wird auf der ITO-beschichteten Seite des Substrats verteilt. Anschließend wird die überstehende Lösung durch Rotation des Tellers bei 800 U/min mit geschlossenem Deckel über den Zeitraum von 30 s abgeschleudert. Danach wird das so beschichtete Substrat 5 min lang bei 200 °C auf einer Heizplatte getrocknet. Die Schichtdicke beträgt 85 nm (Tencor, Alphastep 500).

### 3. Aufbringen der Emitterschicht

5 ml einer 1 Gew.-% Xylol-Lösung des Emitters Green 1300 LUMATION™ (Dow Chemical Company) werden filtriert (Millipore HV, 0,45 µm) und auf der getrockneten lochinjizierenden Schicht verteilt. Dieser und alle weiteren Prozessschritte werden in reiner N₂-Atmosphäre durchgeführt (Inertgas-Gloveboxsystem, M.Braun, Garching). Die Lochinjektionsschicht wird zuvor in der Glovebox nochmals für 5 min bei 200 °C nachgetrocknet. Anschließend wird die überstehende Lösung des Emitters durch Rotation des Tellers bei 400 U/min mit geschlossenem Deckel 30 s lang abgeschleudert. Danach wird das so beschichtete Substrat 15 min lang bei 130 °C auf einer Heizplatte getrocknet. Die Gesamtschichtdicke beträgt 185 nm.

### 4. Aufbringen der Metallkathode

Auf die Emitterschicht wird eine Metallelektrode gedampft. Das Substrat wird mit der Emitterschicht nach unten auf eine Streifenmaske mit 2,0 mm breiten Streifen gelegt, die senkrecht zu den ITO-Streifen orientiert ist. Aus zwei Aufdampfschiffchen werden bei einem Druck von p = 10⁻³ Pa nacheinander eine 5 nm dicke Ba-Schicht und anschließend eine 200 nm dicke Ag-Schicht aufgedampft. Die Aufdampfraten betragen 10 Å/s für Ba und 20 Å/s für Ag. Die aktive Leuchtfläche am Kreuzungspunkt der beiden Elektroden beträgt 4 mm².

### 5. Verkapselung der OLEDs

Die leicht oxidierbaren Kathoden werden durch Verkapselung vor Korrosion geschützt. Dazu wird die polymeren Schichten manuell am Rand des Substrats mit einem Skalpell entfernt und es wird eine Metallkappe (35mm x 35mm x2mm) als Schutz mit einem Epoxydkleber (UHU Plus, UHU, D) aufgeklebt. In der Metallkappe wird zusätzlich Feuchtigkeitsabsorber (GDO/CA/18x10x0.4, SAES Getters S.p.A., Italien) gesetzt.

### 6. Charakterisierung der OLED

Die beiden Elektroden der organischen LED werden über elektrische Zuführungen mit einer Spannungsquelle verbunden (kontaktiert). Der positive Pol ist mit der ITO-Elektrode, der negative Pol ist mit der Metall-Elektrode verbunden. Die Abhängigkeit des OLED-Stroms und der Elektrolumineszenzintensität (der Nachweis erfolgt mit einer Photodiode (EG&G C30809E)) von der Spannung werden aufgezeichnet. Anschließend wird die Lebensdauer bestimmt, indem ein konstanter Strom von I = 0.32 mA (8 mA/cm²) durch die Anordnung fließt, und die Spannung und Lichtintensität zeitabhängig verfolgt.

### Vergleichsbeispiel 2.1

Herstellung einer OLED mit Poly(3,4-ethylendioxythiophen)/Polystyrolsulfonsäure als lochinjizierender Schicht:

Die Durchführung erfolgt wie in Beispiel 2, mit folgender Abweichung bei Prozessschritt 2.:

### 2. Aufbringen der Lochinjektions-Schicht

Etwa 10 ml einer 1,3 %igen Poly(3,4-ethylendioxythiophen)/Polystyrolsulfonsäure-Lösung (H.C. Starck GmbH, Baytron® P, TP AI 4083), werden filtriert (Millipore HV, 0,45 µm). Das ITO-beschichtete Substrat wird anschließend auf eine Lackschleuder gelegt und die filtrierte Lösung wird auf der ITO-beschichteten Seite des Substrats verteilt. Anschließend wird die überstehende Lösung durch Rotation des Tellers bei 600 U/min mit geschlossenem Deckel über den Zeitraum von 30 s abgeschleudert. Danach wird das so beschichtete Substrat 5 min lang bei 200 °C auf einer Heizplatte getrocknet. Die Schichtdicke beträgt 85 nm.

Das Aufbringen der Metallkathoden gemäß Prozessschritt 4 erfolgte gemeinsam mit den Schichtaufbauten aus Beispiel 2, um Vergleichbarkeit zu gewährleisten.

Ergebnisse der Lebensdauermessungen bei konstantem Strom (I = 8mA/cm²) der Anordnungen aus Beispiel 2 und Vergleichsbeispielen 2.1

| | t = 0 | | t=260h | |
|---|---|---|---|---|
| | U/[V] | L /[rel.Einh.] | U/[V] | L /[rel.Einh.] |
| OLED aus Beispiel 2 | 3,66 | 6,81 | 3,88 | 6,61 |
| OLED aus Vergleichsbeispiel 2.1 | 3,71 | 4,66 | 4,13 | 2,59 |

Die erfindungsgemäße EL-Anordnung mit der lochinjizierenden Schicht enthaltend die erfindungsgemäße Formulierung (Beispiel 1) ist effizienter und hat eine deutlich höhere Lebensdauer verglichen mit der EL-Anordnung, die mit einer lochinjizierenden Schicht aus bekanntem Material (PEDT:PSS aus Vergleichsbeispiel 2.1) aufgebaut ist. Nach 260 h Langzeittest ist nicht nur die Abnahme der Elektrolumineszenzintensität geringer, sondern auch der Spannungsanstieg.

### Beispiel 3.1:

### Herstellung einer Formulierung aus Poly(3,4-ethylendioxythiophen)/Polystyrolsulfonsäure und einem perfluorierten Polymer.

15 g einer entsalzten, 1,36 %igen Polyethylendioxythiophen/Polystyrolsulfonsäure-Lösung (H.C.Starck GmbH, Baytron® P, TP AI 4083 entsalzt) werden mit 4,09 g Nafion®-Lösung (Liquion® 1000, 5wt% solution in 2-Propanol/H₂O, 1000 Aq, Ion Power Inc., US) gemischt. Das Gewichtsverhältnis von PEDT/PSS zu Nafion® entspricht 1:1.

### Beispiel 3.2:

### Herstellung einer Formulierung aus Poly(3,4-ethylendioxythiophen)/Polystyrolsulfonsäure und einem perfluorierten Polymer.

12 g einer entsalzten, 1,36 %igen Polyethylendioxythiophen/Polystyrolsulfonsäure-Lösung (H.C.Starck GmbH, Baytron® P, TP AI 4083 entsalzt) werden mit 3,42 g Nafion®-Lösung (Liquion® 1100, 5wt% solution in 2-Propanol/H₂O, 1100 Aq, Ion Power Inc., US) gemischt. Das Gewichtsverhältnis von PEDT/PSS zu Nafion® entspricht 1:1.

### Beispiel 4.1:

Die erfindungsgemäße Formulierung aus Beispiel 3.1 wird zum Aufbau einer organischen Leuchtdiode (OLED) genutzt. Bei der Herstellung der OLED wird wie in Beispiel 2 vorgegangen, mit folgender Abweichung bei Prozessschritt 2.:

### 2. Aufbringen der Lochinjektions-Schicht

Etwa 10 ml der erfindungsgemäßen Formulierung aus Beispiel 3.1 werden filtriert (Millipore HV, 0,45 µm). Das gereinigte ITO-beschichtete Substrat wird auf eine Lackschleuder gelegt und die filtrierte Lösung wird auf der ITO-beschichteten Seite des Substrats verteilt. Anschließend wird die überstehende Lösung durch Rotation des Tellers bei 800 U/min mit geschlossenem Deckel über den Zeitraum von 30 s abgeschleudert. Danach wird das so beschichtete Substrat 5 min lang bei 200 °C auf einer Heizplatte getrocknet. Die Schichtdicke beträgt 85 nm (Tencor, Alphastep 500).

### Beispiel 4.2:

Die erfindungsgemäße Formulierung aus Beispiel 3.2 wird zum Aufbau einer organischen Leuchtdiode (OLED) genutzt. Bei der Herstellung der OLED wird wie in Beispiel 2 vorgegangen, mit folgender Abweichung bei Prozessschritt 2.:

### 2. Aufbringen der Lochinjektions-Schicht

Etwa 10 ml der erfindungsgemäßen Formulierung aus Beispiel 3.2 werden filtriert (Millipore HV, 0,45 µm). Das gereinigte ITO-beschichtete Substrat wird auf eine Lackschleuder gelegt und die filtrierte Lösung wird auf der ITO-beschichteten Seite des Substrats verteilt. Anschließend wird die überstehende Lösung durch Rotation des Tellers bei 800 U/min mit geschlossenem Deckel über den Zeitraum von 30 s abgeschleudert. Danach wird das so beschichtete Substrat 5 min lang bei 200 °C auf einer Heizplatte getrocknet. Die Schichtdicke beträgt 85 nm (Tencor, Alphastep 500).

### Vergleichsbeispiel 4.3:

Herstellung einer OLED mit Poly(3,4-ethylendioxythiophen)/Polystyrolsulfonsäure als lochinjizierender Schicht:

Die Durchführung erfolgt wie in Beispiel 2, mit folgender Abweichung bei Prozessschritt 2.:

### 2. Aufbringen der Lochinjektions-Schicht

Etwa 10 ml einer entsalzten 1,36 %igen Poly(3,4-ethylendioxythiophen)/Polystyrolsulfonsäure-Lösung (H.C. Starck GmbH, Baytron® P TP AI 4083), werden filtriert (Millipore HV, 0,45 µm). Das ITO-beschichtete Substrat wird anschließend auf eine Lackschleuder gelegt und die filtrierte Lösung wird auf der ITO-beschichteten Seite des Substrats verteilt. Anschließend wird die überstehende Lösung durch Rotation des Tellers bei 600 U/min mit geschlossenem Deckel über den Zeitraum von 30 s abgeschleudert. Danach wird das so beschichtete Substrat 5 min lang bei 200 °C auf einer Heizplatte getrocknet. Die Schichtdicke beträgt 85 nm.

Das Aufbringen der Metallkathoden gemäß Prozessschritt 4 erfolgte gemeinsam mit den Schichtaufbauten aus den Beispielen 4.1 und 4.2, um Vergleichbarkeit zu gewährleisten.

Ergebnisse der Lebensdauermessungen bei konstantem Strom (I = 24 mA/cm²) der Anordnungen aus den Beispielen 4.1, 4.2 und Vergleichsbeispiel 4.3:

| | t = 0 | | t=100h h | |
|---|---|---|---|---|
| | U/[V] | L /[rel.Einh.] | U/[V] | L /[rel.Einh.] |
| OLED aus Beispiel 4.1 | 4,19 | 7,58 | 4,40 | 6,95 |
| OLED aus Beispiel 4.2 | 4,30 | 7,67 | 4,51 | 7,02 |
| OLED aus Vergleichsbeispiel 4.3 | 4,02 | 6,29 | 4,43 | 4,75 |

Die erfindungsgemäßen EL-Anordnungen mit der lochinjizierenden Schicht enthaltend die erfindungsgemäßen Formulierungen (Beispiele 4.1 und 4.2 ) sind effizienter und haben deutlich höhere Lebensdauer verglichen mit der EL-Anordnung, die mit einer lochinjizierenden Schicht aus bekanntem Material (PEDT:PSS aus Vergleichsbeispiel 4.3) aufgebaut ist. Nach 100 h Langzeittest bei hohem Devicestrom ist nicht nur die Abnahme der Elektrolumineszenzintensität, sondern auch der Spannungsanstieg bei den erfindungsgemäßen EL Anordnungen geringer.

## Patentansprüche (Patentansprüche für folgende(n) Vertragsstaat(en): AT, BE, BG, CH, CY, CZ, DE, DK, EE, ES, FI, FR, GR, HU, IE, IS, IT, LI, LT, LU, MC, NL, PL, PT, RO, SE, SI, SK, TR)

1. Formulierung enthaltend
A) wenigstens ein Polythiophen enthaltend wiederkehrende Einheiten der allgemeinen Formel (I), 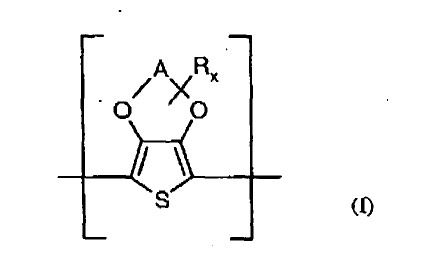 worin
A für einen gegebenenfalls substituierten C₁-C₅-Alkyfenrest, bevorzugt für einen gegebenenfalls substituierten Ethylen- oder Propylenrest steht,
R für einen linearen oder verzweigten, C₁-C₁₈-Alkylrest, einen C₅-C₁₂-Cycloalkylrest, einen C₆-C₁₄-Arylrest, einen C₇-C₁₈-Aralkylrest, einen C₁-C₄-Hydroxyalkylrest oder einen Hydroxylrest steht,
x für eine ganze Zahl von 0 bis 8 steht und
für den Fall, dass mehrere Reste R an A gebunden sind, diese gleich oder unterschiedlich sein können,
B) wenigstens ein SO₃⁻M⁺ - oder COO⁻M⁺-Gruppen enthaltendes Polymer, wobei M⁺ für H⁺, Li⁺, Na⁺, K⁺, Rb⁺, Cs⁺ oder NH₄⁺, bevorzugt für H⁺, Na⁺ oder K⁺ steht, und
C) wenigstens ein SO₃⁻M⁺- oder COO⁻M⁺-Gruppen enthaltendes, teilfluoriertes oder perfluoriertes Polymer, wobei M⁺ für H⁺, Li⁺, Na⁺, K⁺, Rb⁺, Cs⁺ oder NH₄⁺, bevorzugt für H⁺, Na⁺ oder K⁺ steht.

2. Formulierung gemäß Anspruch 1, **dadurch gekennzeichnet, dass** das Polythiophen A) wiederkehrende Einheiten der allgemeinen Formel (Ia) enthält, 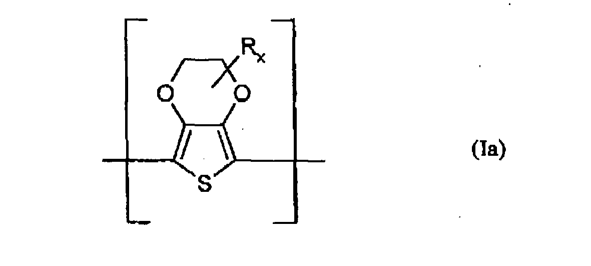 worin
R und x die in Anspruch 1 genannte Bedeutung haben, bevorzugt x für 0 oder 1 steht.

3. Formulierung gemäß wenigstens einem der Ansprüche 1 bis 2, **dadurch gekennzeichnet, dass** sie als wenigstens ein SO₃⁻M⁺- oder COO⁻M⁺-Gruppen enthaltendes Polymer B) Polystyrolsulfonsäure (PSS) enthält.

4. Formulierung gemäß wenigstens einem der Ansprüche 1 bis 3, **dadurch gekennzeichnet, dass** sie als wenigstens ein SO₃⁻M⁺- oder COO⁻M⁺-Gruppen enthaltendes teilfluoriertes oder perfluoriertes Polymer C) ein Copolymer aus Tetrafluorethylen und dem Trifluorvinylether des Poly(hexafluorpropylenoxid)mono(tetrafluorvinylsulfonsäure)-ethers enthält.

5. Formulierung gemäß wenigstens einem der Ansprüche 1 bis 4, **dadurch gekennzeichnet, dass** das Gewichtsverhältnis von Polythiophen(en) A) zu SO₃⁻M⁺- oder COO⁻M⁺-Gruppen enthaltendem(n), teilfluoriertem(n) oder perfluoriertem(n) Polymer(en) C) von 1 zu 2 bis 1 zu 15 beträgt.

6. Formulierung gemäß wenigstens einem der Ansprüche 1 bis 5, **dadurch gekennzeichnet, dass** das Gewichtsverhältnis von Polythiophen(en) A) zu SO₃⁻M⁺- oder COO⁻M⁺-Gruppen enthaltendern(n) Polymer(en) F) von 1 zu 2 bis 1 zu 25 beträgt.

7. Formulierung gemäß wenigstens einem der Ansprüche 1 bis 6, **dadurch gekennzeichnet, dass** sie zusätzlich wenigstens ein polares Verdünnungsmittel enthält.

8. Formulierung gemäß Anspruch 7, **dadurch gekennzeichnet, dass** als polare Verdünnungsmittel D) Wasser, ein Alkohol, insbesondere aus der Reihe Methanol, Ethanol, n-Propanol, 2-Propanol oder n-Butanol oder eine beliebige Mischung, enthaltend wenigstens eines dieser Verdünnungsmittel, verwendet werden.

9. Verwendung der Formulierung gemäß wenigstens einem der Ansprüche 1 bis 8 zur Herstellung lochinjizierender oder lochtranportierender Schichten in elektrolumineszierenden Anordnungen, organischen Solarzellen, organischen Laserdioden, organischen Dünnfilmtransistoren oder organischen Feldeffekttransistoren, zur Herstellung von Elektroden oder elektrisch leitfähiger Beschichtungen.

10. Elelctrolumineszierende Anordnung, insbesondere eine Leuchtdiode, enthaltend wenigstens zwei Elektroden, wovon gegebenenfalls wenigstens eine auf ein gegebenenfalls transparentes Substrat aufgebracht ist, wenigstens eine Emitter-Schicht zwischen den beiden Elektroden und wenigstens eine lochinjizierenden Schicht zwischen einer der beiden Elektroden und der Emitter-Schicht, **dadurch gekennzeichnet, dass** die lochinjizierende Schicht eine Formulierung gemäß einem der Ansprüche 1 bis 8 enthält.

## Patentansprüche (Patentansprüche für folgende(n) Vertragsstaat(en): GB, DE)

1. Formulierung enthaltend
A) wenigstens ein Polythiophen enthaltend wiederkehrende Einheiten der allgemeinen Formel (I), 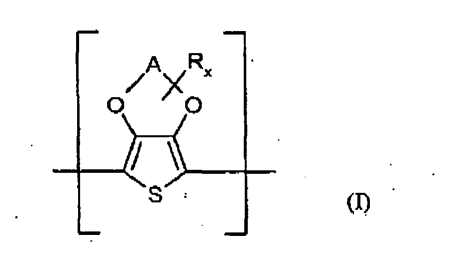 worin
A für einen gegebenenfalls substituierten C₁-C₅-Alkylenrest, bevorzugt für einen gegebenenfalls substituierten Ethylen- oder Propylenrest steht,
R für einen linearen oder verzweigten, C₁-C₁₈-Alkylrest, einen C₅-C₁₂-Cyclo-alkylrest, einen C₆-C₁₄-Arylrest, einen C₇-C₁₈-Aralkylrest, einen C₁-C₄-Hydroxyalkylrest oder einen Hydroxylrest steht,
x für eine ganze Zahl von 0 bis 8 steht und
für den Fall, dass mehrere Reste R an A gebunden sind, diese gleich oder unterschiedlich sein können,
B) wenigstens ein SO₃⁻M⁺- oder COO⁻M⁺-Gruppen enthaltendes Polymer, welches löslich oder dispergierbar ist, wobei M⁺ für H⁺, Li⁺, Na⁺, K⁺, Rb⁺, Cs⁺ oder NH₄⁺, bevorzugt für H⁺, Na⁺ oder K⁺ steht, und
C) wenigstens ein SO₃⁻M⁺- oder COO⁻M⁺-Gruppen enthaltendes, teilfluoriertes oder perfluoriertes Polymer, wobei M⁺ für H⁺, Li⁺, Na⁺, K⁺, Rb⁺, Cs⁺ oder NH₄⁺, bevorzugt für H⁺, Na⁺ oder K⁺ steht.

2. Formulierung gemäß Anspruch 1, **dadurch gekennzeichnet, dass** das Polythiophen A) wiederkehrende Einheiten der allgemeinen Formel (Ia) enthält, 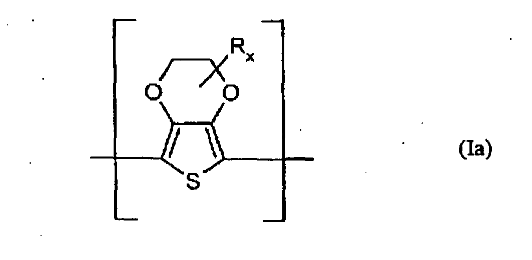 worin
R und x die in Anspruch 1 genannte Bedeutung haben, bevorzugt x für 0 oder 1 steht.

3. Formulierung gemäß wenigstens einem der Ansprüche 1 bis 2, **dadurch gekennzeichnet, dass** sie als wenigstens ein SO₃⁻M⁺- oder COO⁻M⁺-Gruppen enthaltendes Polymer B) Polystyrolsulfonsäure (PSS) enthält.

4. Formulierung gemäß wenigstens einem der Ansprüche 1 bis 3, **dadurch gekennzeichnet, dass** sie als wenigstens ein SO₃⁻M⁺- oder COO⁻M⁺-Gruppen enthaltendes teilfluoriertes oder perfluoriertes Polymer C) ein Copolymer aus Tetrafluorethylen und dem Trifluorvinylether des Poly(hexafluorpropylenoxid)mono(tetrafluorvinylsulfonsäure)-ethers enthält.

5. Formulierung gemäß wenigstens einem der Ansprüche 1 bis 4, **dadurch gekennzeichnet, dass** das Gewichtsverhältnis von Polythiophen(co) A) zu SO₃⁻M⁺- oder COO⁻M⁺-Gruppen enthaltendem(n), teilfluoriertem(n) oder perfluoriertem(n) Polymer(en) C) von 1 zu 2 bis 1 zu 15 beträgt.

6. Formulierung gemäß wenigstens einem der Ansprüche 1 bis 5, **dadurch gekennzeichnet, dass** das Gewichtsverhältnis von Polythiophen(en) A) zu SO₃⁻M⁺- oder COO⁻M⁺-Gruppen enthaltendern(n) Polymer(en) F) von 1 zu 2 bis 1 zu 25 beträgt.

7. Formulierung gemäß wenigstens einem der Ansprüche 1 bis 6, **dadurch gekennzeichnet, dass** sie zusätzlich wenigstens ein polares Verdünnungsmittel enthalt.

8. Formulierung gemäß Anspruch 7, **dadurch gekennzeichnet, dass** als polare Verdünnungsmittel D) Wasser, ein Alkohol, insbesondere aus der Reihe Methanol, Ethanol, n-Propanol, 2-Propanol oder n-Butanol oder eine beliebige Mischung, enthaltend wenigstens eines dieser Verdünnungsmittel, verwendet werden.

9. Verwendung der Formulierung gemäß wenigstens einem der Ansprüche 1 bis 8 zur Herstellung lochinjizierender oder lochtransportierender Schichten in elektrolumineszierenden Anordnungen, organischen Solarzellen, organischen Laserdioden, organischen Dünnfilmtransistoren oder organischen Feldeffekttransistoren, zur Herstellung von Elektroden oder elektrisch leitfähiger Beschichtungen.

10. Elektrolumineszierende Anordnung, insbesondere eine Leuchtdiode, enthaltend wenigstens zwei Elektroden, wovon gegebenenfalls wenigstens eine auf ein gegebenenfalls transparentes Substrat aufgebracht ist, wenigstens eine Emitte-Schicht zwischen den beiden Elektroden und wenigstens eine lochinjizierenden Schicht zwischen einer der beiden Elektroden und der Emitter-Schicht, **dadurch gekennzeichnet, dass** die lochinjizierende Schicht eine Formulierung gemäß einem der Ansprüche 1 bis 8 enthält.

## Claims (Claims for the following Contracting State(s): Patentansprüche für folgende(n) Vertragsstaat(en) : AT, BE, BG, CH, CY, CZ, DE, DK, EE, ES, FI, FR, GR, HU, IE, IS, IT, LI, LT, LU, MC, NL, PL, PT, RO, SE, SI, SK, TR)

1. Formulation comprising
A) at least one polythiophene containing recurring units of the general formula (1) 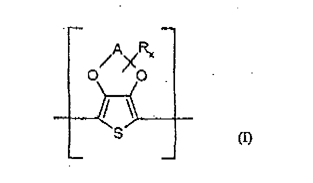 wherein
A represents an optionally substituted C₁-C₅-alkylene radical, preferably an optionally substituted ethylene or propylene radical,
R represents a linear or branched C₁-C₁₈-alkyl radical, a C₅-C₁₂-cycloalkyl radical, a C₆-C₁₄-aryl radical, a C₇-C₁₈-aralkyl radical, a C₁-C₄-hydroxyalkyl radical or a hydroxyl radical,
x represents an integer from 0 to 8, and in the case where a plurality of radicals R are bonded to A, these can be identical or difierent,
B) at least one polymer containing SO₃⁻M⁺ or COO⁻M⁺ groups, wherein M⁺ represents H⁺, Li⁺, Na⁺, K⁺, Rb⁺ Cs⁺ or NH₄⁺, preferably H⁺, Na⁺ or K⁺, and
C) at least one partially fluorinated or perfluorinated polymer containing SO₃⁻M⁺ or COO⁻M⁺ groups, wherein M⁺ represents H⁺, Li⁺, Na⁺, K⁺, Rb⁺, Cs⁺ or NH₄⁺, preferably H⁺, Na⁴ or K⁺.

2. Formulation according to Claim 1, **characterized in that** the polythiophene A) contains recurring units of the general formula (Ia) 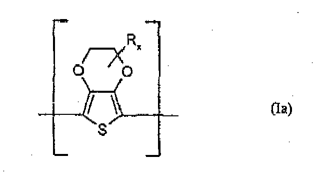 wherein
R and x are each as defined in Claim 1 and preferably x represents 0 or 1.

3. Formulation according to at least one of Claims 1 to 2, **characterized in that** the at least one polymer B) containing SO₃⁻M⁺ or COO⁻M⁺ groups is polystyrenesulfonic acid (PSS).

4. Formulation according to at least one of Claims 1 to 3, **characterized in that** the at least one partially fluorinated or perfluorinated polymer C) containing SO₃⁻M⁺ or COO⁻M⁺ groups is a copolymer of tetrafluoroethylene and the trifluorovinyl ether of the poly(hexafluoropropylene oxide) mono(tetrafluorovinylsulfonic acid) ether.

5. Formulation according to at least one of Claims 1 to 4, **characterized in that** the weight ratio of polythiophene(s) A) to partially fluorinated or perfluorinated polymer(s) C) containing SO₃⁻M⁺ or COO⁻M⁴ groups is in the range from 1:2 to 1:15.

6. Formulation according to at least one of Claims 1 to 5, **characterized in that** the weight ratio of polythiophene(s) A) to polymer(s) F) containing SO₃⁻M⁺ or COO⁻M⁺ groups is in the range from 1:2 to 1:25.

7. Formulation according to at least one of Claims 1 to 6, **characterized in that** it additionally comprises at least one polar diluent.

8. Formulation according to Claim 7, **characterized in that** the polar diluents D) are water, alcohol, in particular from the series methanol, ethanol, n-propanol, 2-propanol or n-butanol or any desired mixture containing at least one of these diluents.

9. Use of the formulation according to at least one of Claims 1 to 8 for the production of hole-injecting or hole-transporting layers in electroluminescent arrangements, organic solar cells, organic laser diodes, organic thin film transistors or organic field effect transistors, for the production of electrodes or electrically conductive coatings.

10. Electroluminescent arrangement, in particular a light emitting diode, comprising at least two electrodes, of which optionally at least one is applied to an optionally transparent substrate, at least one emitter layer between the two electrodes and at least one hole-injecting layer between one of the two electrodes and the emitter layer, **characterized in that** the hole-injecting layer comprises a formulation according to any one of Claims 1 to 8.

## Claims (Claims for the following Contracting State(s): GB, DE)

1. Formulation comprising
A) at least one polythiophene containing recurring units of the general formula (I) 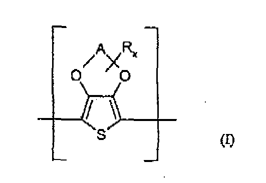 wherein
A represents an optionally substituted C₁-C₅-alkylene radical, preferably an optionally substituted ethylene or propylene radical,
R represents a linear or branched C₁-C₁₈-alkyl radical, a C₅-C₁₂-cycloalkyl radical, a C₆-C₁₄-aryl radical, a C₇-C₁₈-aralkyl radical, a C₁-C₄-hydroxyalkyl radical or a hydroxyl radical,
x represents an integer from 0 to 8, and in the case where a plurality of radicals R are bonded to A, these can be identical or different,
B) at least one soluble or dispersible polymer containing SO₃⁻M⁺ or COO⁻M⁺ groups, wherein M⁺ represents H⁺, Li⁺, Na⁺, K⁺, Rb⁺, Cs⁺ or NH₄⁺, preferably H⁺, Na⁺ or K⁺, and
C) at least one partially fluorinated or perfluorinated polymer containing SO₃⁻M⁺ or COO⁻M⁺ groups, wherein M⁺ represents H⁺, Li⁺, Na⁺, K⁺, Rb⁺, Cs⁺ or NH₄⁺, preferably H⁺, Na⁺ or K⁺.

2. Formulation according to Claim 1, **characterized in that** the polythiophene A) contains recurring units of the general formula (Ia) 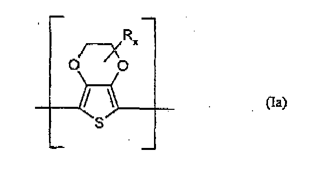 wherein
R and x are each as defined in Claim 1 and preferably x represents 0 or 1.

3. Formulation according to at least one of Claims 1 to 2, **characterized in that** the at least one polymer B) containing SO₃⁻M⁺ or COO⁻M⁺ groups is polystyrenesulfonic acid (PSS).

4. Formulation according to at least one of Claims 1 to 3, **characterized in that** the at least one partially fluorinated or perfluorinated polymer C) containing SO₃⁻M⁺ or COO⁻M⁺ groups is a copolymer of tetrafluoroethylene and the trifluorovinyl ether of the poly(hexafluoropropylene oxide) mono(tetrafluorovinylsulfonic acid) ether.

5. Formulation according to at least one of Claims 1 to 4, **characterized in that** the weight ratio of polythiophene(s) A) to partially fluorinated or perfluorinated polymer(s) C) containing SO₃⁻M⁺ or COO⁻M⁺ groups is in the range from 1:2 to 1:15.

6. Formulation according to at least one of Claims 1 to 5, **characterized in that** the weight ratio of polythiophene(s) A) to polymer(s) F) containing SO₃⁻M⁺ or COO⁻M⁺ groups is in the range from 1:2 to 1:25.

7. Formulation according to at least one of Claims 1 to 6, **characterized in that** it additionally comprises at least one polar diluent.

8. Formulation according to Claim 7, **characterized in that** the polar diluents D) are water, alcohol, in particular from the series methanol, ethanol, n-propanol, 2-propanol or n-butanol or any desired mixture containing at least one of these diluents.

9. Use of the formulation according to at least one of Claims 1 to 8 for the production of hole-injecting or hole-transporting layers in electroluminescent arrangements, organic solar cells, organic laser diodes, organic thin film transistors or organic field effect transistors, for the production of electrodes or electrically conductive coatings.

10. Electroluminescent arrangement, in particular a light emitting diode, comprising at least two electrodes, of which optionally at least one is applied to an optionally transparent substrate, at least one emitter layer between the two electrodes and at least one hole-injecting layer between one of the two electrodes and the emitter layer, **characterized in that** the hole-injecting layer comprises a formulation according to any one of Claims 1 to 8.

## Revendications (Revendications pour l'(les) Etat(s) contractant(s) suivant(s): Patentansprüche für folgende(n) Vertragsstaat(en) : AT, BE, BG, CH, CY, CZ, DE, DK, EE, ES, FI, FR, GR, HU, IE, IS, IT, LI, LT, LU, MC, NL, PL, PT, RO, SE, SI, SK, TR)

1. Composition contenant
A) au moins un polythiophène contenant des motifs répétitifs de formule générale (I) 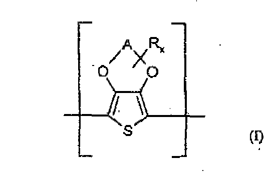 dans laquelle
A représente un radical alkylène en C₁-C₅ éventuellement substitué, de préférence un radical éthylène ou propylène éventuellement substitué,
B représente un radical alkyle en C₁-C₁₈ linéaire ou ramifié, un radical cycloalkyle en C₅-C₁₂, un radical aryle en C₆-C₁₄, un radical aralkyle en C₇-C₁₈, un radical hydroxyalkyle en C₁-C₄ ou un radical hydroxy,
x représente un nombre entier allant de 0 à 8 et dans le cas où plusieurs radicaux R sont liés à A, des derniers peuvent être identiques ou différents,
B) au moins un polymère contenant des groupes SO₃⁻M⁺ ou COO⁻M⁺, M⁺ représentant H⁺, Li⁺, Na⁺, K⁺, Rb⁺, Cs⁺ ou NH₄⁺, de préférence H⁺, Na⁺ ou K⁺, et
C) au moins un polymère perfluoré ou partiellement fluoré, contenant des groupes SO₃⁻M⁺ ou COO⁻M⁺, M⁺ représentant H⁺, Li⁺, Na⁺, K⁺, Rb⁺, Cs⁺ ou NH₄⁺, de préférence H⁺, Na⁺ ou K⁺.

2. Composition selon la revendication 1, **caractérisée en ce que** le polythiophène A) contient des motifs répétitifs de formule générale (Ia) 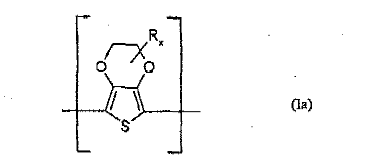 dans laquelle
R et x ont les significations données dans la revendication 1, de préférence x représente 0 ou 1.

3. Composition selon au moins l'une des revendications 1 et 2, **caractérisée en ce qu'**elle contient, en tant qu'au moins un polymère B) contenant des groupes SO₃⁻M⁺ ou COO⁻M⁺, du poly(acide styrènesulfonique).

4. Composition selon au moins l'une des revendications 1 à 3, **caractérisée en ce qu'**elle contient, en tant qu'au moins un polymère perfluoré ou partiellement fluoré C), contenant des groupes SO₃⁻M⁺ ou COO⁻M⁺, un copolymère de tétrafluoroéthylène et de l'éther trifluorovinylique du poly(hexafluorooxypropylène)mono(tétrafluorovinylsulfonyl)-éther.

5. Composition selon au moins l'une des revendications 1 à 4, **caractérisée en ce que** le rapport pondéral du/des polythiophène(s) A) au(x) polymère(s) perfluoré(s) ou partiellement fluoré(s) (C), contenant des groupes SO₃⁻M⁺ ou COO⁻M⁺, va de 1:2 à 1:15.

6. Composition selon au moins l'une des revendications 1 à 5, **caractérisée en ce que** le rapport pondéral du/des polythiophène(s) A) au(x) polymère(s) F), contenant des groupes SO₃⁻M⁺ ou COO⁻M⁺, va de 1:2 à 1:25.

7. Composition selon au moins l'une des revendications 1 à 6, **caractérisée en ce qu'**elle contient additionnellement au moins un diluant polaire.

8. Composition selon la revendication 7, **caractérisée en ce qu'**en tant que diluant polaire D) on utilise l'eau, un alcool, en particulier choisi parmi le méthanol, l'éthanol, le n-propanol, le 2-propanol et le n-butanol, ou un mélange quelconque contenant au moins un de ces diluants.

9. Utilisation de la composition selon au moins l'une des revendications 1 à 8, pour la production de couches injectrices de trous ou de couches transporteuses de trous dans des dispositifs électroluminescents, des cellules solaires organiques, des diodes laser organiques, des transistors organiques à film mince ou des transistors organiques à effet de champ, pour la fabrication d'électrodes ou de revêtements conducteurs de l'électricité.

10. Dispositif électroluminescent, en particulier une diode luminescente, comportant au moins deux électrodes, dont éventuellement au moins une est appliquée sur un substrat éventuellement transparent, au moins une couche émettrice entre les deux électrodes et au moins une couche injectrice de trous entre l'une des deux électrodes et la couche émettrice, **caractérisé en ce que** la couche injectrice de trous contient une composition selon l'une quelconque des revendications 1 à 8.

## Revendications (Revendications pour l'(les) Etat(s) contractant(s) suivant(s): GB, DE)

1. Composition contenant
A) au moins un polythiophène contenant des motifs répétitifs de formule générale (I) 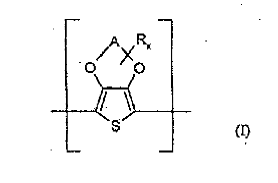 dans laquelle
A représente un radical alkylène en C₁-C₅ éventuellement substitué, de préférence un radical éthylène ou propylène éventuellement substitué,
B. représente un radical alkyle en C₁-C₁₈ linéaire ou ramifié, un radical cycloalkyle en C₅-C₁₂, un radical aryle en C₆-C₁₄, un radical aralkyle en C₇-C₁₈, un radical hydroxyalkyle en C₁-C₄ ou un radical hydroxy,
x représente un nombre entier allant de 0 à 8 et dans le cas où plusieurs radicaux R sont liés à A, des derniers peuvent être identiques ou différents,
B) au moins un polymère soluble ou dispersible et contenant des groupes SO₃⁻M⁺ ou COO⁻M⁺, M⁺ représentant H⁺, Li⁺, Na⁺, K⁺, Rb⁺, Cs⁺ ou NH₄⁺, de préférence H⁺, Na⁺ ou K⁺, et
C) au moins un polymère perfluoré ou partiellement fluoré, contenant des groupes SO₃⁻M⁺ ou COO⁻M⁺, M⁺ représentant H⁺, Li⁺, Na⁺, K⁺, Rb⁺, Cs⁺ ou NH₄⁺, de préférence H⁺, Na⁺ ou K⁺.

2. Composition selon la revendication 1, **caractérisée en ce que** le polythiophène A) contient des motifs répétitifs de formule générale (la) 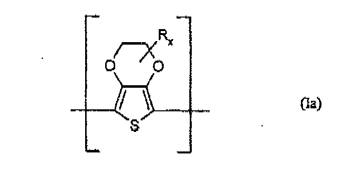 dans laquelle
R et x ont les significations données dans la revendication 1, de préférence x représente 0 ou 1.

3. Composition selon au moins l'une des revendications 1 et 2, **caractérisée en ce qu'**elle contient, en tant qu'au moins un polymère B) contenant des groupes SO₃⁻M⁺ ou COO⁻M⁺, du poly(acide styrènesulfonique).

4. Composition selon au moins l'une des revendications 1 à 3, **caractérisée en ce qu'**elle contient, en tant qu'au moins un polymère perfluoré ou partiellement fluoré C), contenant des groupes SO₃⁻M⁺ ou COO⁻M⁺, un copolymère de tétrafluoroéthylène et de l'éther trifluorovinylique du poly(hexafluorooxypropylène)mono(tétrafluorovinylsulfonyl)-éther.

5. Composition selon au moins l'une des revendications 1 à 4 , **caractérisée en ce que** le rapport pondéral du/des polythiophène(s) A) au(x) polymêre(s) perfluoré(s) ou partiellement fluoré(s) (C), contenant des groupes SO₃⁻M⁺ ou COO⁻M⁺, va de 1:2 à 1:15.

6. Composition selon au moins l'une des revendications 1 à 5, **caractérisée en ce que** le rapport pondéral du/des polythiophène(s) A) au(x) polymère(s) F), contenant des groupes SO₃⁻M⁺ ou COO⁻M⁺, va de 1:2 à 1:25.

7. Composition selon au moins l'une des revendications 1 à 6, **caractérisée en ce qu'**elle contient additionnellement au moins un diluant polaire.

8. Composition selon la revendication 7, **caractérisée en ce qu'**en tant que diluant polaire D) on utilise l'eau, un alcool, en particulier choisi parmi le méthanol, l'éthanol, le n-propanol, le 2-propanol et le n-butanol, ou un mélange quelconque contenant au moins un de ces diluants.

9. Utilisation de la composition selon au moins l'une des revendications 1 à 8, pour la production de couches injectrices de trous ou de couches transporteuses de trous dans des dispositifs électroluminescents, des cellules solaires organiques, des diodes laser organiques, des transistors organiques à film mince ou des transistors organiques à effet de champ, pour la fabrication d'électrodes ou de revêtements conducteurs de l'électricité.

10. Dispositif électroluminescent, en particulier une diode luminescente, comportant au moins deux électrodes, dont éventuellement au moins une est appliquée sur un substrat éventuellement transparent, au moins une couche émettrice entre les deux électrodes et au moins une couche injectrice de trous entre l'une des deux électrodes et la couche émettrice, **caractérisé en ce que** la couche injectrice de trous contient une composition selon l'une quelconque des revendications 1 à 8.
